# EUROPEAN PATENT APPLICATION

(11) **EP 2 000 237 A1**
(43) Date of publication of application: **10.12.2008**
(21) Application number: 07739648.9
(22) Date of filing: 26.03.2007
(51) Int. Cl.: B23B 27/14, C04B 35/583, C23C 14/06, C23C 14/34

(54) **SURFACE-COATED TOOL**

(30) Priority: 28.03.2006 JP 2006087809; 28.12.2006 JP 2006354420
(71) Applicant: Kyocera Corporation, Kyoto-shi, Kyoto-fu 612-8501 (JP)
(72) Inventor: ZHU, Yaocan, Kagoshima 895-0211 (JP); NODA, Kenji, Kagoshima 895-0211 (JP); MATSUZAWA, Masahito, Kagoshima 895-0211 (JP)
(74) Representative: HOFFMANN EITLE
(86) International application number: PCT/JP2007/056210
(87) International publication number: WO 2007/111301

(57) **Abstract**

A surface coated tool including a substrate, and stacked layers composed of two coating layers represented by the following general formula (1) on the substrate is provided. A first coating layer to be coated on the surface of the substrate, which has a thickness of 0.1 to 1 µm, is composed of a granular crystal having a mean crystal diameter of 0.01 to 0.1µm. A second coating layer to be coated on the surface of the first coating layer, which has a thickness of 0.5 to 5 µm, is composed of columnar crystal grown in a direction perpendicular to the substrate, and the columnar crystal has a mean crystal width of 0.05 to 0.3µm in a direction parallel to the substrate while a mean crystal width thereof is larger than the mean crystal diameter of the first coating layer.

[Formula 3] M₁-ₐAlₐ(C_{b}N_{1-b}) (1)

wherein, M represents at least one metal element selected from the group consisting of the elements of Groups 4, 5 and 6 of the periodic table, Si and rare earth elements, "a" satisfies the relation of 0.25 ≤ a ≤ 0.75, and "b" satisfies the relation of 0 ≤ b ≤ 1.

## Description

### TECHNICAL FIELD

The present invention relates to a surface coated tool forming a hard coating layer on a surface of a substrate.

### BACKGROUND ART

Recently, the surface coated tool is obtained by forming various hard coating layers on a surface of a hard material such as WC-based cemented carbide and TiCN-based cermet so as to improve sliding performance, wear resistance and fracture resistance. Particularly a hard coating layer formed by physical vapor deposition method, which has high hardness and high wear resistance, is widely used for various purposes. A TiAIN layer is formed by are ion plating method and sputtering method as the physical vapor deposition method, and is considered improvement for extending the life of the cutting tool.

For example, Patent Document No. 1 describes that a hard layer is configured by alternately stacking the TiAlN layer having low hardness and the TiAIN layer having high hardness, so that adhesion to the substrate of the hard layer and wear resistance are improved. The hard layer described as a concrete example is obtained by alternately stacking the low hardness layer formed under the condition of -10 to -30 V of bias voltage, containing Al at the rate of 0.1 to 0.4, and the high hardness layer formed under the condition of -50 to -100 V of the bias voltage, containing Al at the rate of 0.4 to 0.75.

In the hard coating layer stacked alternately the TiAIN layer having low hardness and the TiAIN layer having high hardness described in Patent Document No. 1, it is possible to improve adhesion of the substrate and wear resistance of the hard coating layer. In contrast, unevenness on the surface of the substrate and variations of a nucleation status at the initial phase of layer formation cause heterogeneous structure and composition in the hard coating layer, so that wear resistance and fracture resistance as a whole hard coating layer are not necessarily sufficient. Particularly, a cutting tool having a sharp cutting edge and used for precision work that required smoothness of a finished surface has the following problems. That is, minute layer peeling and chipping occur on the cutting edge at the initial phase of work, finished surface roughness deteriorates, thereby the tool life becomes shorter.

Patent Document No. 2 describes that a multilayer-coated hard tool is obtained by alternately forming [A] layer having Ti rate of 75 to 98 at% by target of (Ti_{0.95}Al_{0.05}) and (Ti_{0.85}Al_{0.15}) and being oriented in (111) plane, and forming [B] layer having Ti rate of 20 to 65 at% by target of (Ti_{0.5}Al_{0.5}) and (Ti_{0.3}Al_{0.7}) and oriented in (200) plane by ion plating method. In the interface between [A] layer and [B] layer, epitaxial growth is suppressed, many lattice defects are introduced, and residual compressive stress of the layer is relaxed, so that thickening of the layer can be achieved.

As described in Patent Document No. 2, the multilayer-coated hard tool obtained by alternately forming [A] layer having high Ti ratio (namely, Al ratio is low) by target that has high Ti ratio, and forming [B] layer having low Ti ratio (namely, Al ratio is high) by target that has low Ti ratio, enables thickening of the layer, so that chipping and layer peeling can be restrained. In contrast, there are problems that hardness of the hard coating layer decreases and wear resistance deteriorates. Further, because of introduction of many lattice defects, TiAIN layer growth is heterogeneous, homogeneity of the hard coating layer is impaired, and finished surface roughness is liable to deteriorate.

Patent Document No. 3 describes that the film permitting an improvement of wear resistance of the layer and having fracture resistance is formed by forming the TiAlN layer having a grain diameter of 50 nm or less on the surface of the base material. Patent Document No. 4 describes that a hard layer-coated tool having a stable long life is obtained when the height/width ratio of the crystal grain diameter in the TiAIN hard layer is in the range of 1 to 7, that is, the shape of the crystal grain diameter of the TiAIN hard layer is columnar crystal to be long lengthwise.

However, the layer having a grain diameter of 50 nm or less in the TiAIN layer, as described in Patent Document No. 3, improves wear resistance, whereas internal stress excessively accumulates therein. Therefore, fracture resistance is deteriorated due to a deficiency of a stress relaxation mechanism for decreasing the internal stress, and peeling and chipping of the hard coating layer may be occurred. In the method that the crystal grain diameter of the TiAIN hard layer is formed in the shape of columnar crystal to be long lengthwise as described in the Patent Document No. 4, it is difficult to control the structure of the columnar crystal uniformly only by specifying an average value of the height/width ratio of the crystal grain diameter, due to a nucleation of hard coating layer caused along the nature of the surface of the substrate, thereby the crystal sizes have variations. In particular, minute layer peeling and the chipping occur in the cutting edge, finished surface roughness is deteriorated, and tool life becomes shorter.

On the other hand, a cubic boronitride (hereinafter referred to simply as a "cBN") has high hardness second to diamond, and does not have affinity with iron-based metal unlike diamond. Therefore, a cBN-based cutting tool composed of cBN as the substrate is applicable to cutting under severe condition, such as high speed cutting and heavy interrupted cutting at low speed for iron-based material, in particular, hardened steel and cast iron.

Recently, the cBN-based cutting tool is also used in precision work that is for a work material having diameter of 30 mm or less and required extremely smooth surface roughness of a cutting surface and cutting accuracy. Therefore, excellent cutting performance, that is, smoothness and cutting accuracy of the cutting surface, and strength enduring low speed cutting are further required.

The coating layer is formed on the surface of the cBN-based cutting tool by are ion plating method or sputtering method as physical vapor deposition so as to obtain a sufficient cutting performance in the cutting, and improvement of the coating layer is considered in order to extend the tool life.

In Patent Document No. 5, for example, wear resistance and fracture resistance are improved by forming the TiAIN layer on the surface of the substrate composed of cBN or diamond.
However, forming the TiAIN layer on the cBN-based cutting tool by ion plating method as described in Patent Document No. 5, has a limit to make roughness of the cutting surface smaller, because roughness of the cutting edge becomes large due to existence of the grain grown anomalously on the surface of the tool and the work material has tendency to be welded into cutting edge. Additionally, in precision work at low speed for a fine object, layer peeling is caused by the impact on the cutting edge, which leads to occurrence of anomalous wear and welding.

Patent Document No. 6 describes that multilayered structure is composed of a first coating layer having a maximum peak in (200) plane and a second coating layer having a maximum peak in (111) plane, so that both adhesion force and layer strength can be improved.

However, when the first layer is coated by low bias, a contact area with the substrate becomes small due to the enlargement of the mean grain diameter of the hard layer, thereby the adhesion force of the hard layer is not necessarily sufficient, layer peeling occurs quickly. Further, the second layer is coated by high bias, so that many droplets are caused and surface roughness of the tool becomes large.

Patent Document No. 1: Japanese Unexamined Patent Publication No. 11-61380
Patent Document No. 2: Japanese Unexamined Patent Publication No. 9-323205
Patent Document No. 3: Japanese Unexamined Patent Publication No. 6-220608
Patent Document No. 4: Japanese Unexamined Patent Publication No. 10-315011
Patent Document No. 5: Japanese Unexamined Patent Publication No. 08-119774
Patent Document No. 6: Japanese Unexamined Patent Publication No. 10-330914

### DISCLOSURE OF THE INVENTION

### PROBLEMS TO BE SOLVED BY THE INVENTION

The main advantage of the present invention is to provide a surface coated tool with a hard coating layer which has fine and homogeneous structure irrespective of condition such as unevenness of a substrate surface and the like, and has excellent wear resistance and fracture resistance.
Other advantage of the present invention is to provide the surface coated cutting tool that keeps the surface status thereof smooth, and exerts excellent cutting performance in a precision work required sufficient adhesion force.

### MEANS FOR SOLVING THE PROBLEMS

The intensive research of the present inventors has led to the present invention based on the following new finding. That is, when two specified coating layers are stacked on a substrate surface, a hard coating layer has a fine and homogeneous structure irrespective of condition such as unevenness of the substrate surface and the like, so that both of wear resistance and fracture resistance of the hard coating layer can be sufficiently exhibited.

That is, the surface coated tool of the present invention comprises a substrate and a hard coating layer comprising two coating layers stacked on the surface of the substrate, and the coating layers are represented by the following general formula (1). A first coating layer to be coated on the surface of the substrate, which has a thickness of 0.1 to 1 µm, is composed of a granular crystal having a mean crystal diameter of 0.01 to 0.1µm. A second coating layer to be coated on the surface of the first coating layer, which has a thickness of 0.5 to 10 µm, is composed of columnar crystal grown in a direction perpendicular to the substrate, and the columnar crystal has a mean crystal width of 0.05 to 0.3µm in a direction parallel to the substrate while a mean crystal width of the second coating layer is larger than the mean crystal diameter of the first coating layer.

[Formula 1] M₁-ₐAlₐ(C_{b}N_{1-b}) (1)

wherein, M represents at least one metal element selected from the group consisting of the elements of Groups 4, 5 and 6 of the periodic table, Si and rare earth elements, "a" satisfies the relation of 0.25 ≤ a ≤ 0.75, and "b" satisfies the relation of 0 ≤ b ≤ 1.

In the first coating layer of the above structure, in order to accelerate homogeneous nucleation at the time of forming the second coating layer, and increase hardness of the first coating layer, it is preferable that "a" in the general formula (1) satisfy the relation of 0.55 ≤ a ≤ 0.75.
Further, in the second coating layer of the above structure, in order to generate columnar crystal having high toughness of the second coating layer readily, and control mean crystal width of the columnar crystal readily, it is preferable that "a" in the general formula (1) satisfy the relation of 0.4 ≤ a ≤ 0.55.
In the above structure, it is preferable that a TiN layer having a thickness of 0.05 to 1µm exist on the surface of the second coating layer so as to check easily with eyes if the tool was used or not.
It is preferable that the coating layer be a sputtering layer so as to form the structure of the coating layer homogeneous. More specifically, this is because that the coating layer having extremely smoothed surface roughness in the surface of the hard layer, which has few defects such as anomalous growth of the grain and excrescence at the time of layer formation, can be formed, therefore, tool life can be extended.

Additionally, since the substrate surface has high hardness, when the substrate is a cBN substrate comprising cBN sintered body, even if the cBN substrate is hard to form the coating layer thereon, adhesiveness of the coating layer can be sufficiently achieved in precision work for the fine object of hardened steel.

The cBN substrate comprises a hard phase composed mainly of cBN, formed by bonding with a binding phase, and it is preferable that the binding phase contain titanium nitride and titanium carbide so as to improve the adhesiveness between the coating layer and the cBN substrate.
In order to improve the adhesiveness between the substrate and the coating layer as well as cutting accuracy of the tool, it is preferable that the surface of the coating layer be yet to be polished and maximum height Rz be in the range of 0.05 to 0.5 µm.

The method of manufacturing a work piece according to the present invention is preferable to include the steps as described below in order to obtain the work piece that cutting surface roughness (finished surface roughness) improves. That is, firstly, a cutting tool, in which a surface coated tool contains the substrate comprising the cemented carbide that formed a cutting edge at a crossed ridge portion between a rake face and a flank face, is prepared. Then, the edge is brought into contact with a surface of a work material. Subsequently, the work material is cut by rotating the cutting edge. Thereafter, the cutting edge is taken away from the surface of the work material. A first preferred example for the substrate is cemented carbide. In the method of manufacturing the work piece, alloy steel and carbon steel are preferably used as the work material, and precision grooving turning process and milling operation are conducted as preferred embodiments for cutting. It is therefore preferable that the above-mentioned work material and cutting be used for finishing that can be reduced cutting surface roughness.

A second preferred example for substrate is cBN sintered body. In the method of manufacturing the work piece by using the substrate comprising cBN sintered body, particularly when the work material is hardened steel having a diameter of 30 mm or less, it is capable of performing excellent cutting that can obtain the work piece the cutting surface roughness improved.

### EFFECT OF THE INVENTION

According to the surface coated tool of the present invention, the coating layer represented by the above-mentioned general formula (1) is composed of a first coating layer and a second coating layer. The first coating layer of the substrate side, which has a thickness of 0.1 to 1 µm, is composed of a granular crystal having a mean crystal diameter of 0.01 to 0.1µm. Then, the second coating layer coated on the surface of the first coating layer, which has a thickness of 0.5 to 10 µm, is composed of columnar crystal grown in a direction perpendicular to the substrate, the columnar crystal has a mean crystal width of 0.05 to 0.3µm and a mean crystal width of the second coating layer is larger than the mean crystal diameter of the first coating layer. Hence, the first coating layer uniforms the substrate surface having a plurality of unevenness and flaws, so that the second coating layer is capable of achieving minute and homogeneous nucleation on the surface of the first coating layer. As a result, crystal growth in the second coating layer, which is formed on the even surface of the first coating layer, becomes columnar and minute, so that the hard coating layer as a whole, the surface coated tool has homogeneous structure and composition of the hard coating layer irrespective of unevenness of the substrate surface, and has high wear resistance and fracture resistance of the hard coating layer. Additionally, thickness of each coating layer is controlled to the above-mentioned range, so that the crystal shapes such as granular crystal and columnar crystal in the hard coating layer can be accomplished, both wear resistance and fracture resistance can be consistent.

In the first coating layer, satisfying the relation of 0.55 ≤ a ≤ 0.75 is preferable, which controls the mean crystal diameter in the first coating layer within the range of 0.01 to 0.1 µm, accelerates homogeneous nucleation at the time of forming the second coating layer, and increases hardness of the first coating layer.
In the second coating layer, satisfying the relation of 0.4 ≤ a ≤ 0.55 is preferable, which generates columnar crystal having high toughness, and controls mean crystal width of the columnar crystal readily.
When the TiN layer having a thickness of 0.05 to 1µm exists on the surface of the second coating layer, the surface of the surface coated tool is gold. Once the surface coated tool is used, the TiN layer disappears, and the surface color is no longer gold, so that it can be checked easily with eyes if the tool was used or not.
In order to form homogeneous structure without occurrence of abnormal portion such as droplet generated at the time of forming by arc ion plating method, it is preferable that the coating layer be coated by sputtering method.

Since the substrate surface has high hardness, when the substrate is the cBN substrate composed of cBN sintered body that is formed by bonding the hard phase composed mainly of cBN with the binding phase, even if the cBN substrate is hard to be formed the coating layer thereon, adhesiveness of the coating layer can be sufficiently achieved in precision work for the fine object of hardened steel, and welding is reduced in precision work for the fine object of a work material having high hardness, thereby high cutting accuracy can be obtained, and long life tool can be achieved. Since the first coating layer is composed of fine particles, hardness of the coating layer is close to the hard phase of cBN, and stress occurring at the time of layer formation is optimized. Thereby, even when the substrate is composed of cBN sintered body having a weak affinity for other material, adhesiveness can be efficiently achieved in precision work for the fine object of hardened steel.

Hence, to form the coating layer on the surface of the cBN substrate composed of ultra- high pressure sintered body makes the surface of the cutting edge extremely smooth. Therefore, the cutting surface roughness of the work material can be prevented from deteriorating due to occurrence of constitutive cutting edge caused by welding of the work material and chatter caused by high cutting resistance, layer peeling of the coating layer can be prevented owing to increasing adhesiveness of the coating layer, and excellent cutting surface roughness can be achieved even after long time cutting.
According to the method of manufacturing the work piece of the present invention, the work piece which the cutting surface roughness improved can be obtained.

### BRIEF DESCRIPTION OF THE DRAWINGS

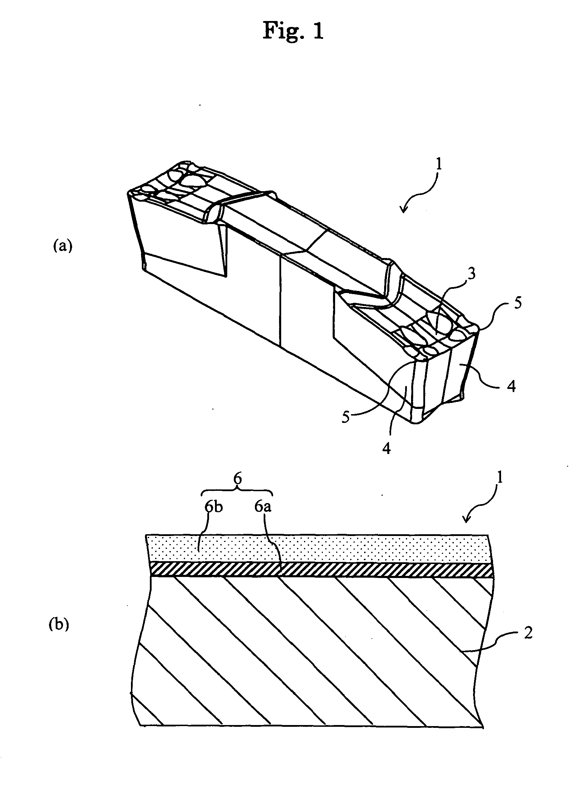

Fig. 1(a) is a schematic perspective view showing an example of a surface coated cutting tool according to a preferred embodiment of a surface coated tool of the present invention; Fig. 1(b) is a partly enlarged schematic sectional view showing a surface of the surface coated cutting tool and its surroundings in Fig. 1(a);

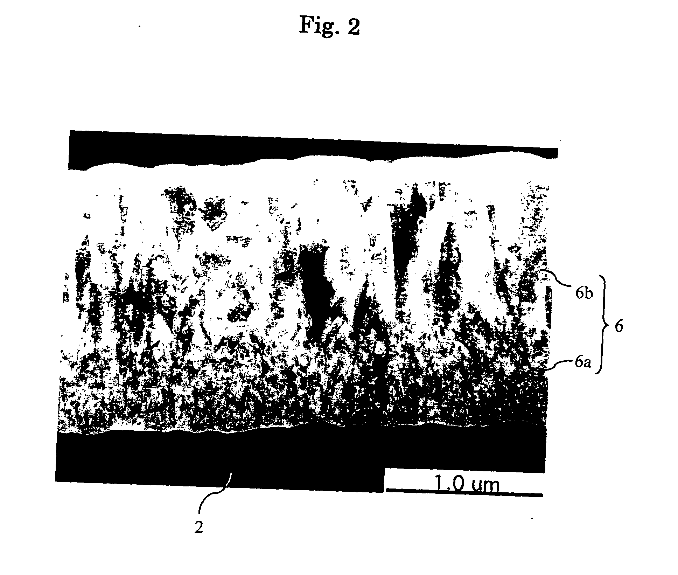

Fig. 2 is an enlarged microscope image showing a section of a surface of the surface coated cutting tool and its surroundings in the preferred embodiment of the surface coated tool of the present invention;

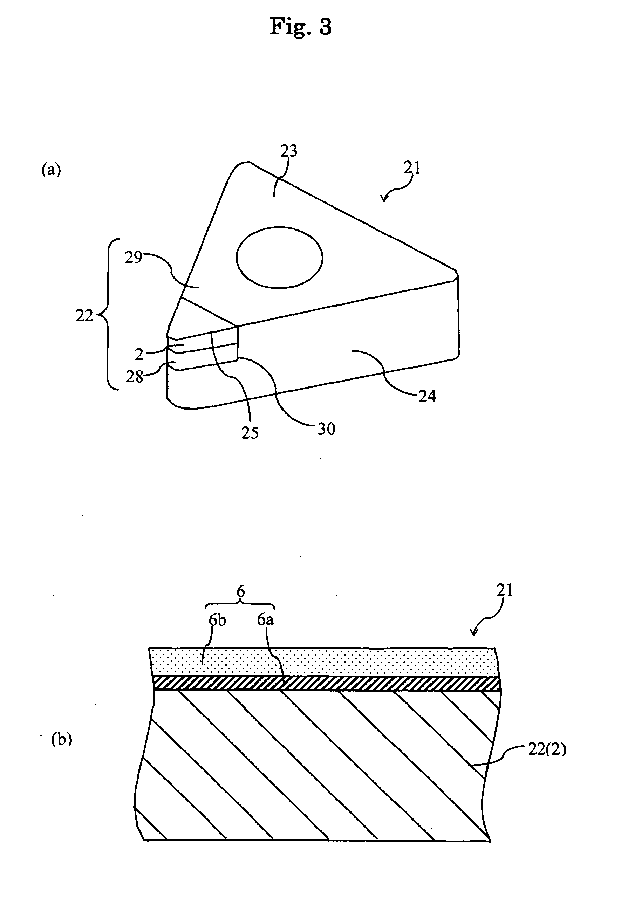

Fig. 3(a) is a schematic perspective view showing other example of the surface coated cutting tool according to a preferred embodiment of a surface coated tool of the present invention; and Fig. 3(b) is a partly enlarged schematic sectional view showing the surface of the surface coated cutting tool and its surroundings in Fig. 3(a).

### PREFERRED EMBODIMENTS FOR CARRYING OUT THE INVENTION

### Surface coated (cutting) tool

The surface coated cutting tool, preferred embodiment of the surface coated tool of the present invention, will be described in detail with reference to the accompanying drawings. Fig. 1(a) is a schematic perspective view showing an example of the surface coated cutting tool, and Fig. 1(b) is a partly enlarged schematic sectional view showing a surface of the surface coated cutting tool and its surroundings in Fig. 1(a). Fig. 2 is an enlarged microscope image showing a section of the surface of the surface coated cutting tool and its surroundings.

As shown in Fig. 1(a), a surface coated cutting tool (hereinafter referred to simply as a "tool") 1 has a rake face 3 on a main surface, a flank face 4 on the side surface, and a cutting edge 5 at a crossed ridge portion between the rake face 3 and the flank face 4, then forms a hard coating layer (hereinafter referred to simply as a "coating layer") 6 on a substrate 2.

As shown in Fig. 1(b) and Fig. 2, the hard coating layer 6 is composed of the structure that stacked at least two coating layers represented by the general formula (1), on the surface of the substrate 2. A first coating layer 6a coated on the substrate 2 side, which has a thickness of 0.1 to 1 µm, is composed of a granular crystal having a mean crystal diameter of 0.01 to 0.1µm, and a second coating layer 6b coated on the surface of the first coating layer 6a, which has a thickness of 0.5 to 10 µm, is composed of columnar crystal grown in a direction perpendicular to the substrate 2, the columnar crystal has a mean crystal width of 0.05 to 0.3µm, and a mean crystal width of the columnar crystal is larger than the mean crystal diameter of the first coating layer 6a. Hence, granular crystal constituting the first coating layer 6a uniforms the surface of the substrate 2 having a plurality of unevenness and flaws, so that the second coating layer 6b is capable of achieving homogeneous nucleation on the surface of the first coating layer 6a. As a result, crystal growth in the second coating layer 6b formed on the even surface of the first coating layer 6a can be minute, the hard coating layer 6 as a whole, fracture resistance of the hard coating layer 6 can be homogeneous irrespective of unevenness of the surface of the substrate 2, and tool 1 having high wear resistance and high fracture resistance of hard coating layer 6 can be achieved. Particularly, thickness of each coating layers 6a and 6b is controlled in above-mentioned range, so that the coating layers 6a and 6b can be controlled to above-mentioned crystal grain diameter, wear resistance and fracture resistance can be consistent.

It can be confirmed as follows whether the first coating layer 6a and the second coating layer 6b consist of specific composition described above, respectively. Namely, for example, the surface of the hard coating layer 6 is observed with a scanning electronic microscope (SEM) or a transmission electron microscope (TEM), confirmed the presence of the first coating layer 6a and the second coating layer 6b, and measured the thickness, the crystal grain diameter of the granular crystal, and the mean crystal width of the columnar crystal, in each coating layer. When a scanning electronic microscope (SEM) or a transmission electron microscope (TEM) is used for observation, the composition at any three points in each coating layer is measured with energy dispersive spectroscopy (EDS). Then, a mean value of the measured values is calculated as composition in each coating layer.

More specifically, a mean crystal diameter (a mean grain diameter) of the granular crystal (granular grain) in the first coating layer 6a means the circle diameter that obtained by observing the structure in any surfaces or cross sections in the first coating layer 6a with a scanning electronic microscope or a transmission electron microscope, measuring an area of each grain that constitutes the first coating layer 6a and is observed in field of view of 100 nm × 100 nm or more by image analysis method, calculating a mean value thereof, and then converting the mean value to a circle having the same area.

A mean crystal width (a mean grain width) paralleled to the surface of the substrate 2 of the columnar crystal (columnar grain) in the second coating layer 6b is obtained by observing the structure in any cross sections in the second coating layer 6b with a scanning electronic microscope or a transmission electron microscope, measuring the crystal width paralleled to the surface of the substrate in any thicknesses direction in the grains that constitutes the second coating layer 6b and is observed in field of view of 100 nm ×100 nm or more, and calculating a mean value thereof.

In the general formula (1), a metal element M represents at least one metal element selected from the group consisting of the elements of Groups 4, 5 and 6 of the periodic table, Si and rare earth elements. For example, M may contain Ti, Zr, Hf, V, Nb, Ta, Cr, Mo and W as the elements of Groups 4, 5 and 6 of the periodic table, and Y, Yb, Er and Ce as the rare earth elements. The metal element M is preferable to contain Ti having high hardness. Further, "a" satisfies the relation of 0.25 ≤ a ≤ 0.75, and "b" satisfies the relation of 0 ≤ b ≤ 1.

On the other hand, in the composition of the coating layer represented by the general formula (1), when "a" is less than 0.25, wear resistance will be deteriorated, and when "a" is more than 0.75, fracture resistance will be deteriorated.

When the thickness of the first coating layer 6a is less than 0.1 µm, the effect of uniforming the surface of the substrate 2 is not provided sufficiently, the mean crystal width in the second coating layer 6b becomes partly big, homogeneity is detracted, thereby wear resistance decreases. When the thickness of the first coating layer 6a is more than 1 µm, the effect of relaxing stress by the coating layer having high fracture resistance such as the second coating layer 6b is not provided, thereby fracture resistance of the whole hard coating layer 6 may deteriorate. Further, when the mean crystal diameter in the first coating layer 6a is less than 0.01µm, consistency of crystal grains that are between in the first coating layer 6a, in the substrate 2 and in the second coating layer 6b becomes low, and adhesion between layers may be deteriorated. When the mean crystal diameter in the first coating layer 6a is more than 0.1µm, fine and homogeneity crystal growth in the second layer 6b may not be obtained.

The thickness of the second coating layer 6b is 0.5µm or more, the second coating layer 6b can be columnar crystal, and the coating layer having high toughness can be achieved. On the other hand, the thickness of the second coating layer 6b is 10µm or less, so that internal stress is adequate, and the hard coating layer being hard to peel can be obtained. The preferable range of the thickness of the second coating layer 6b depends on usage. For example, when it is used for precision bore cutting, 0.5 to 5 µm is applicable, and when it is used for milling operation, 1 to 8µm is applicable. Additionally, the crystal constituting the second coating layer 6b is the columnar crystal grown in a direction perpendicular to the substrate 2, so that high toughness can be obtained, thereby the hard layer having high fracture resistance can be achieved.

The mean crystal width of the columnar crystal is 0.05µm or more, so that toughness of the second coating layer 6b can be increased. The mean crystal width of the columnar crystal is 0.05µm or less, the surface of the second coating layer 6b can be smooth, and finished surface roughness of the cutting surface can be smooth. When the mean crystal width of the columnar crystal constituting the second coating layer 6b is the same or less than the mean crystal diameter of the crystal constituting the first coating layer 6a, inner stress of the hard coating layer 6 increases, hardness of the second coating layer 6b decreases, thereby fracture resistance deteriorates.

A1 content (a) in the first coating layer 6a preferably satisfies the relation of 0.55≤a≤0.75, that is, 55 to 75at % by atom with respect to the content of all metal elements (metal element M selected at least one from the group consisting of the elements of Groups 4, 5 and 6 of the periodic table, Si and rare earth elements, and Al) in the first coating layer 6a. Hence, mean crystal diameter in the first coating layer 6a can be controlled within the range of 0.01 to 0.1 µm, homogeneous nucleation on the surface of the substrate 2 can be accelerated, and hardness of the first coating layer 6a can be increased.

When Al atomic percentage and Ti atomic percentage, which are contained in the second coating layer 6b, bring the total to 1, the content ofAl atom is preferably not less than 0.50 nor more than 0.75. The content of A1 atom to the total amount of A1 atom and Ti atom exceeds 0.50, so that oxidation of the surface of the second coating layer 6b can be suppressed, and deterioration of the surface roughness on the second coating layer 6b due to oxidation can be suppressed. Hence, if temperature of the cutting edge becomes high due to cutting, reactivity with a work material can be decrease, and welding of the work material can be suppressed. As a result, deterioration of the cutting surface roughness due to occurrence of constitutive cutting edge that hardened the cutting surface by reacting deposit with cutting edge surface can be prevented. The content of Al atom to total amount of Al atom and Ti atom is 0.75 or less, so that crystal structure of the second coating layer 6b can be cubic crystal having high hardness, and deterioration of wear resistance of the second coating layer 6b can be suppressed.

A1 content (a) in the second coating layer 6b preferably satisfies the relation of 0.4≤a≤0.55. Hence, generation of the columnar crystal in the second coating layer 6b and mean crystal width of columnar crystal can be controlled within the predetermined range.

It is preferable that the TiN layer having a thickness of 0.05 to 1µm exist on the surface of the second coating layer 6b, so that the surface of the tool 1 is gold. Once the tool 1 is used, the TiN layer disappears and the surface color is no longer gold, so that it can be checked easily with eyes if the tool was used or not.

It is possible that the hard layer of different material is formed between the first coating layer 6a and the second coating layer 6b as a middle layer. However, it is preferable that the first coating layer and the second coating layer be formed continuously so as to suppress layer peeling and chipping. Moreover, other coating layer having a thickness of 0.2 µm or less may be formed between the substrate 2 and the first coating layer 6a.

It is preferable that the coating layers 6a and 6b be a sputtered film. Hence, homogeneous structure can be achieved without occurrence of abnormal grains such as droplet generated at the time of layer formation by arc ion plating method, and cutting surface roughness of the work material can be improved.

In order that the tool 1 has high wear resistance and can decrease cutting resistance at the time of cutting, it is preferable that the arithmetic mean roughness (Ra) on the surface of the hard coating layer 6 be 0.12 µm or less. Alternatively, in order that the tool 1 has high wear resistance and can decrease cutting resistance at the time of cutting, it is preferable that the maximum height (Rz) on the surface of the coating layer 6 be in the range of 0.05 to 0.5 µm. Moreover, in order that adhesion of the coating layer 6 is sufficient and nucleation becomes homogeneous, it is preferable that the maximum height (Rz) on the interface between the substrate 2 and the coating layer 6 be in the range of 0.02 to 0.1 µm. When the coating layers 6a and 6b are sputtering layers, structure is homogeneous and the surface is smooth, so that it is not necessary to be subjected to machining. That is, it is preferable that the surface of the coating layer 6 be unpolished.

On the surface of the hard coating layer 6, the arithmetic mean roughness Ra and the maximum height Rz are measured according to JIS B0601'01, using a probe type surface roughness meter, under the conditions of 0.25 mm in cutoff value, 0.8 mm in reference length and 0.1 mm/sec in scanning speed. Additionally, in order that adhesion of the coating layer 6 is sufficient and nucleation becomes homogeneous, it is preferable that the arithmetic mean roughness Ra and the maximum height Rz on the interface between the substrate 2 and the coating layer 6 be in the range of 0.05 to 0.3 µm. The arithmetic mean roughness on the interface between the substrate 2 and the hard coating layer 6 is obtained by tracing the interface between the substrate 2 and the hard coating layer 6 based on the cross-sectional photograph, which took tool 1 containing the interface between the substrate 2 and the hard coating layer 6 for drawing curved line, and calculating based on the curved line as the value corresponding to the arithmetic mean roughness according to JIS B0601'01.

As the substrate 2, it is preferable to use hard material. That is, for example, cemented carbide, which is formed by the hard phase composed mainly of tungsten carbide or titanium carbonitride and the binding phase composed mainly of iron group metal such as cobalt or nickel, cermet, ceramic composed mainly of silicon nitride or aluminum oxide, and ultra-high pressure sintered body obtained by sintering the hard phase composed of polycrystalline diamond or cBN and binding phase composed of ceramic or iron group metal under ultra-high pressure.

In particular, when the method of manufacturing the work piece described below is applied to the tool 1, it is preferable that the substrate 2 be composed of cemented carbide that is a first preferred example in order to exert the excellent cutting performance.
On the other hand, for example, when the work material composed of hardened steel having a diameter of 30 mm or less is cut, it is preferable to use the tool described below. Then, the substrate 2 is preferably composed of cBN sintered body that is a second preferred example. The tool will be described below.

Fig. 3(a) is a schematic perspective view showing other example of the tool, and Fig. 3(b) is a partly enlarged schematic sectional view showing the surface of the tool in Fig. 3(a). In Fig. 3, the same reference numerals have been used for identical components in the above-mentioned configurations shown in Figs. 1 to 2, with the description thereof omitted.

As shown in Fig. 3, in a cutting tool 21 as a surface coated cBN-based cutting tool, a base material is obtained that the substrate 2 (cBN sintered body) is cut out into the predetermined shape by wire discharge or the like, jointed with a backing cemented carbide 28, and then subjected to brazing to a cut-in step parts 30 formed on a tip portion of the cutting edge of a cemented carbide base 29. The base material 22 is composed of a rake face 23 on a main surface, flank face 24 on a side surface, and a cutting edge 25 on a crossed ridge portion between a rake face 23 and a flank face 24, and coated with the coating layer 6 on the surface thereof.

In the tool 21 of the present embodiment, the substrate 2 is composed of the cBN sintered body formed by bonding the hard phase composed mainly of cBN with the binding phase. Specifically, for example, cBN-based sintered body, which is containing the hard phase composed of 20 to 95 % by mass of cBN to the total mass of the hard phase and binding phase, can be used.

As the binding phase, for example, the metal such as cobalt, nickel, aluminum or the like, or substance composed mainly of ceramic such as titanium nitride (TiN), titanium carbide (TiC) or the like may be used. Particularly, it is preferable that the binding phase contain titanium nitride (TiN) and titanium carbide (TiC) in order to increase adhesion to the coating layer 6 and suppress layer peeling and chipping of cutting edge. Specifically, it is preferable that TiN and TiC coexist in the binding phase in order to increase strength of the substrate 2, be more closely to the hardness of the coating layer 6 containing Ti and Al, and improve fracture resistance and adhesion force.

The grain diameter of cBN grain constituting the substrate 2 is 0.2 to 5.0 µm, preferably 0.5 to 3.0 µm, in view of wear resistance and strength. The grain diameter of cBN grain is obtained by measuring the image that took at a magnification of 1000 to 5000 with a scanning electron microscope (SEM) by using a general image analyzer such as LUZEX.

Existence of the middle layer containing compound other than the above-mentioned binding phase component among carbide, nitride, carbonitride, boride, borocarbide, boronitride and oxide of at least one element selected from the group consisting of metals in Groups 4, 5 and 6 of the periodic table, iron group metal and Al, in periphery of the cBN grain is preferable in view of holding cBN grain steady. The structure makes it possible that the hardness of the first coating layer 6a is close to the hardness of the substrate 2 containing the hard phase composed mainly of cBN, the stress generating at the time of layer formation becomes optimal, adhesion of the coating layer 6 is sufficiently assured, and layer peeling is suppressed. Otherwise, the configuration is identical to the tool 1, and the description thereof is therefore omitted here.

Next, the method of manufacturing the tool 1 will be described. Firstly, the substrate 2 as a tool shape is formed by a known forming method. Then, the hard coating layer 6 having the above-mentioned structure is formed on the surface of the substrate 2. As a specific method of layer formation, physical vapor deposition (PVD), such as ion plating method, sputtering method or the like, is used. The detailed method of the layer formation is exemplified that when the hard coating layer containing titanium (Ti) and Aluminum (Al) is formed by sputtering method, metal targets of two or more of metallic titanium (Ti) and metallic aluminum (Al) are independently used, or alloy thereof is used as a target, the metal material is evaporated and ionized by arc discharge and glow discharge, while reacted with nitrogen (N₂) gas of nitrogen source and methane (CH₄)/ acetylene (C₂H₂) gas of carbon source.

As a target used for forming the second coating layer, the hard coating layer 6 can be formed by adding metal target containing no Al or with a low Al content such as titanium (Ti) metal target, in addition to the target used for layer formation of the first coating layer 6a, and applying higher bias voltage than applying at forming the second coating layer 6b at the time of forming the first coating layer 6a. In the hard coating layer 6 formed by the method, Al content in the first coating layer 6a is larger than in the second coating layer 6b.

Next, the method of manufacturing the tool 21 will be described. Firstly, as a raw material powder, cBN raw material powder having determined mean grain diameter in the range of 0.2 to 3 µm, the powder composed of at least one selected from carbide, nitride and carbonitride of at least one element selected from the group consisting of metals in Groups 4, 5 and 6 of the periodic table and having the mean grain diameter of 0.2 to 3µm, preferably 0.5 to 3µm, more preferably 1 to 3µm, and raw material powder composed of at least one selected from Al and iron group metal having the mean grain diameter of 0.5 to 5µm, if needed, are weighed to predetermined composition, and are finely ground and mixed in the ball mill for 16 to 72 hours.

Then, the powder mixture may be formed to the determined shape, if needed. For forming, a known forming means, such as pressing, injection molding, slip casting, extrusion and the like, is used.

Further, ultra-high pressure sintering apparatus is charged with the powder mixture and a backing member composed of cemented carbide separately prepared, and hold at a determined temperature in the range of 1200 to 1400°C, under pressure of 5 GPa and for 10 to 30 minutes, so that the substrate 2 composed of cBN sintered body can be obtained. In order to form a structure that carbide in the group consisting of metals in Groups 4, 5 and 6 of the periodic table and nitride in the group consisting of metals in Groups 4, 5 and 6 of the periodic table exist respectively, it is preferable that rate of temperature increase and rate of temperature decrease be set to 30 to 50°C/min, and duration of holding the heating (sintering time) be 10 to 15 minutes. It is therefore capable of decreasing failure due to sintering.

The obtained substrate 2 (cBN sintered body) is thereafter brazed to the cut-in step parts 30 of the cemented carbide base 29, so that the base material 22 can be formed. The tool 21, which is surface coated cBN-based cutting tool, can be obtained by forming the coating layer 6 on the surface of the base material 22 as the same manner as in the tool 1.

The first coating layer 6a is formed by applying higher bias voltage than applying to the second coating layer 6b at the time of forming, particularly 100 V or higher, preferably 120 V or higher, so that the hard coating layer composed of fine grains smaller than that of the second coating layer 6b can be formed. The second coating layer 6b is formed by applying a bias voltage lower than 100 V, particularly lower than 80 V, so that abnormal grains are hard to occur on the surface, and the hard coating layer that has smooth surface can be formed. In the coating layer 6 formed by the means, Al content in the first coating layer 6a is higher than Al content in the second coating layer 6b. Otherwise, the configuration is identical to the tool 1, and the description thereof is therefore omitted here.

### Method of Manufacturing a work piece

Next, an embodiment according to the method of manufacturing a work piece of the present invention will be described. In the method of manufacturing the work piece according to the embodiment, the tool 1 and the tool 21 are respectively used.

### Method of Manufacturing a work piece by using tool 1

In the use of the tool 1, in order to exert excellent cutting performance, it is preferable that the substrate 2 be composed of cemented carbide that is the first preferred example. Examples of the cutting include turning process in which the work material, such as metal work to be cut, is rotated, and milling operation in which the cutting tool 1 is rotated. In particular, both turning process and milling operation are preferably used for finishing.

Specifically, the method of manufacturing a work piece by using the tool 1 includes the step of preparing the cutting tool 1 having a cutting edge 5 formed at a crossed ridge portion between the rake face 3 and the flank face 4, the step of bringing the cutting edge 5 into contact with the surface of the work material, the step of cutting the work material by rotating the cutting edge 5, and the step of taking the cutting edge 5 away from the surface of the work material. Hence, the work piece having improved cutting surface roughness can be obtained. Namely, as mentioned above, the homogeneity of the hard coating layer 6 in the cutting edge 5 of the tool 1 is high owing to high homogeneity of the hard coating layer 6 of the tool 1, and smoothness of the surface of the hard coating layer 6 is also high, so that finished surface roughness of the work material at the time of cutting is high.

### Method of Manufacturing a work piece by using tool 21

In the use of the tool 21, the substrate 2 is composed of cBN sintered body that is the second preferred example. Then, the tool 21 is suitable for cutting the work material composed of hardened steel having a diameter of 30 mm or less. As the cutting method, both of the turning process and the milling operation are applicable. Further, even in the turning process that is prone to welding of the work material, it is capable of extending the life of the cutting tool.

Specifically, the method of manufacturing a work piece by using the tool 21 includes the step of preparing the cutting tool 21 having the cutting edge 25 formed at a crossed ridge portion between the rake face 23 and the flank face 24, the step of bringing the cutting edge 25 into contact with the surface of the work material composed of hardened steel having a diameter of 30 mm or less, the step of cutting the work material by rotating either the cutting edge 25 or the work material, and the step of taking the cutting edge 25 away from the surface of the work material. Hence, the work piece having improved cutting surface roughness can be obtained. Namely, as mentioned above, the homogeneity of the coating layer 6 in the cutting edge 25 of the tool 21 is high owing to high homogeneity of the coating layer 6 of the tool 21, and smoothness of the surface of the coating layer 6 is also high, so that finished surface roughness of the work material at the time of cutting is high.

The present invention will be described in more detail based on the following Examples, which are cited merely by way of example and without limitation.

### Example I

### Manufacturing of Cutting Tools

A mixture was obtained by mixing tungsten carbide (WC) powder that is a main component and has a mean grain diameter of 0.8 µm, 10% by mass of metal cobalt (Co) powder having a mean grain diameter of 1.2 µm, 0.2% by mass of vanadium carbide (VC) powder having a mean grain diameter of 1.0 µm, and 0.6% by mass of chromium carbide (Cr₃C₂) powder having a mean grain size of 1.0 µm. Then, above mixture was press-formed into a shape of cutting tool for grooving (GBA43R300MY, grooving chip, manufactured by KYOCERA Corporation) having triangle shape. This was then subjected to debinding process, followed by sintering in vacuum of 0.01 Pa at 1450°C for one hour, thereby manufacturing cemented carbide. The surface of rake face of each sample was polished by blasting or brushing. The cemented carbide was further subjected to cutting edge treatment (honing) by brushing, so that the substrate was obtained.

A hard coating layer was formed on the substrate in various kinds of composition as shown in Table 1 by sputtering method. As for Sample No. I-7, a TiN layer having a thickness of 0.2 µm was formed on the surface of the first coating layer and the second coating layer shown in Table 1.

The surface of the hard coating layer of the samples thus obtained was observed with a scanning electronic microscope (SEM) or a transmission electron microscope (TEM), confirmed the presence of the first coating layer and the second coating layer, and measured the thickness, the crystal grain diameter of the granular crystal, and the mean crystal width of the columnar crystal in each coating layer. When a scanning electronic microscope (SEM) or a transmission electron microscope (TEM) was used for observation, the composition at any three points in each coating layer was measured with energy dispersive spectroscopy (EDS). Then, a mean value of the measured values was calculated as composition in each coating layer.

The arithmetic mean roughness Ra in the surface of the hard coating layer (the surface of the second coating layer) was measured at any three points with a probe type surface roughness meter, and a mean value thereof was calculated. Specifically, the measurement was conducted with a probe type surface roughness meter according to JIS B0601'01, under the conditions of 0.25 mm in cutoff value, 0.8 mm in reference length and 0.1 mm/sec in scanning speed. The interface between the substrate and the first coating layer was traced with use of the photograph that was taken by the microscope for observation, and the obtained shape was used for measuring the arithmetic mean roughness Ra in the interface according to JIS B0601'01.

### Cutting Test

Next, under the following conditions, the cutting test of the obtained throwaway chip (cutting tool) having a shape of the cutting tool for grooving was conducted. The results are presented in Table 2.
Cutting method: Continuous turning process
Work material: SCM435
Cutting speed: 250 m/min
Feed rate: 0.08 mm/rev
Cutting depth: 2 mm in shoulder of slot, 4 mm in depth of slot
Cutting condition: Wet cutting
Evaluation method: The finished surface roughness (cutting surface roughness Ra) of the machined work material was measured after 10 minutes of cutting. The cutting edge was observed with a microscope, and flank wear amount, nose wear amount and the presence of chipping were measured after 20 minutes of cutting.

**[Table 1]**

| Sample No. ¹⁾ | Bias voltage (V) | | Structure of hard coating layer | | | | | | | | |
|---|---|---|---|---|---|---|---|---|---|---|---|
| | | | First coating layer | | | | Second coating layer | | | | Whole thickness (µm) |
| | First coating layer | Second coating layer | Form of crystal | Mean crystal diameter (µm) | Composition | Thickness (µm) | Form of crystal | Mean crystal width (µm) | Composition | Thickness (µm) | |
| I-1 | 120 | 100 | Granular form | 0.06 | (Ti_{0.4}Al_{0.6})N | 0.5 | Columnar form | 0.18 | (Ti_{0.5}Al_{0.5})N | 2 | 2.5 |
| I-2 | 120 | 100 | Granular | 0.07 | (Ti_{0.4}Al_{0.58}Y_{0.02})N | 0.2 | Columnar | 0.15 | (Ti_{0.5}Al_{0.5})N | 2.3 | 2.5 |
| I-3 | 150 | 120 | Granular form | 0.06 | (Ti_{0.35}Al_{0.63}Ce_{0.02})(C_{0.5}N_{0.5}) | 0.5 | Columnar form | 0.15 | (Ti_{0.55}Al_{0.45})(C_{0.5}N_{0.5}) | 2.5 | 3 |
| I-4 | 120 | 90 | Granular form | 0.05 | (Ti_{0.1}Al_{0.7}Cr_{0.2})(C_{0.5}N_{0.5}) | 0.3 | Columnar | 0.2 | (Ti_{0.4}Al_{0.50}Cr_{0.2})(C_{0.5}N_{0.5}) | 2.2 | 2.5 |
| I-5 | 150 | 130 | Granular form | 0.04 | (Ti_{0.15}Al_{0.6}Cr_{0.2}Si_{0.05})N | 1.0 | Columnar form | 0.25 | (Ti_{0.5}Al_{0.5})N | 2 | 3 |
| I-6 | 150 | 100 | Granular | 0.06 | (Ti_{0.25}Al_{0.6}Nb_{0.1}Si_{0.05})N | 0.8 | Columnar form | 0.23 | (Ti_{0.5}Al_{0.5})N | 2.2 | 3 |
| I-7 | 150 | 80 | Granular form | 0.07 | (Ti_{0.4}Al_{0.6})(C_{0.5}N_{0.5}) | 0.3 | Columnar form | 0.26 | (Ti_{0.5}Al_{0.5})(C_{0.5}N_{0.5}) | 2.5 | 3(2.8) |
| I-8 | 200 | 80 | form | 0.08 | Granular. (Ti_{0.35}Al_{0.65})(C_{0.5}N_{0.5}) | 0.2 | Columnar form | 0.15 | (Ti_{0.35}Al_{0.45})N₁₀ | 3 | 3.2 |
| I-9 | 250 | 150 | Granular form | 0.05 | (Ti_{0.35}Al_{0.55}Si_{0.1})N | 0.5 | Columnar form | 0.12 | (Ti_{0.5}Al_{0.5})N | 2.5 | 3 |
| I-10 | 150 | 80 | Granular form | 0.05 | (Ti_{0.1}Al_{0.56}Cr_{0.2}Si_{0.04})N | 0.5 | Columnar form | 0.16 | (Ti_{0.5}Al_{0.5})N | 2.5 | 3 |
| * I-11 | 80 | - | Granular form | 0.2 | (Ti_{0.5}Al_{0.5})N | 3 | - | | | | 3 |
| * I-12 | 50 | 300 | Columnar form | 0.12 | (Ti_{0.48}Al_{0.52})(C_{0.5}N_{0.5}) | 0.5 | Granular form | 0.08 | (Ti_{0.45}Al_{0.55})(C_{0.5}N_{0.5}) | 2 | 2.5 |
| * I-13 | 100 | 100 | Granular form | 0.2 | (Ti_{0.4}Al_{0.5}Cr_{0.1})(C_{0.5}N_{0.5}) | 0.5 | Columnar form | 0.4 | (Ti_{0.65}Al_{0.45})N | 2.5 | 3 |
| * I-14 | 300 | 100 | Granular form | 0.2 | (Ti_{0.5}Al_{0.5})(C_{0.5}N_{0.5}) | 0.5 | Granular form | 0.2 | (Ti_{0.5}Al_{0.5})(C_{0.5}N_{0.5}) | 2.5 | 3 |
| * I-15 | 200 | 100 | Granular form | 0.05 | (Ti_{0.35}Al_{0.65})N | 2 | Columnar | 0.2 | (Ti_{0.5}Al_{0.5})N form | 2 | 4 |

| | | | | | | | | | | | |
|---|---|---|---|---|---|---|---|---|---|---|---|
| 1) The samples marked "*" are out of the scope of the present invention. | | | | | | | | | | | |

**[Table 2]**

| Sample No. ¹⁾ | Surface roughness of substrate Ra (µm) | Surface roughness of hard coating layer Ra (µm) | Cutting performance | | | |
|---|---|---|---|---|---|---|
| | | | Presence of chipping | Flank wear (mm) | Tip wear (mm) | Cutting surface roughness Ra (µm) |
| I-1 | 0.06 | 0.06 | None | 0.19 | 0.18 | 0.10 |
| I-2 | 0.06 | 0.07 | None | 0.18 | 0.15 | 0.11 |
| I-3 | 0.10 | 0.11 | None | 0.2 | 0.16 | 0.13 |
| I-4 | 0.10 | 0.12 | None | 0.20 | 0.19 | 0.13 |
| I-5 | 0.06 | 0.09 | None | 0.13 | 0.14 | 0.12 |
| I-6 | 0.06 | 0.08 | None | 0.13 | 0.12 | 0.12 |
| I-7 | 0.06 | 0.07 | None | 0.18 . | 0.16 | 0.10 |
| I-8 | 0.10 | 0.11 | None | 0.16 | 0.15 | 0.12 |
| I-9 | 0.10 | 0.12 | None | 0.20 | 0.19 | 0.14 |
| I-10 | 0.10 | 0.11 | None | 0.12 | 0.14 | 0.12 |
| * I-11 | 0.06 | 0.09 | Presence | 0.35 | 0.31 | 0.21 |
| * I-12 | 0.06 | 0.10 | Presence | 0.32 | 0.35 | 0.25 |
| * I-13 | 0.10 | 0.12 | Initial fracture | - | - | - |
| * I-14 | 0.10 | 0.11 | Presence | 0.40 | 0.45 | 0.32 |
| * I-15 | 0.06 | 0.10 | Presence | 0.38 | 0.35 | 0.28 |

| | | | | | | |
|---|---|---|---|---|---|---|
| 1) The samples marked "*" are out of the scope of the present invention. | | | | | | |

According to the results shown in Tables 1 and 2, in Sample No. I-11 that was coated by only the first coating layer composed of the granular crystal, the tool life was short due to occurrence of chipping quickly. In Sample No. I-12, in which the mean crystal diameter of the first coating layer was more than 0.1 µm, the tool life was also short due to occurrence of chipping quickly. In Sample No. I-13, in which the mean crystal width of the second coating layer was more than 0.3 µm, hardness and wear resistance of the second coating layer deteriorated. In Sample No. I-14, in which the mean crystal diameter of the first coating layer was more than 0.1 µm and the mean crystal diameter of the first coating layer was the same as the mean crystal width of the second coating layer, inner stress of the hard coating layer increased and toughness of the second coating layer decreased, so that fracture resistance decreased. In the Sample No. I-15, in which the thickness of the first coating layer 6a was more than 1 µm, there was no effect that the stress was relaxed by the coating layer having high fracture resistance like the second coating layer, so that fracture resistance of whole hard coating layer deteriorated.

On the other hand, Sample Nos. I-1 to I-10 that were within the scope of the present invention had a smooth and homogeneous hard coating layer with a high fracture resistance, and demonstrated an excellent finished surface roughness..

### Example II

### Manufacturing of Cutting Tools

A mixture was obtained by mixing tungsten carbide (WC) powder that is a main component and has a mean grain diameter of 0.8 µm, 10% by mass of metal cobalt (Co) powder having a mean grain diameter of 1.2 µm, 0.2% by mass of vanadium carbide (VC) powder having a mean grain diameter of 1.0 µm, and 0.6% by mass of chromium carbide (Cr₃C₂) powder having a mean grain size of 1.0 µm. Then, above mixture was press-formed into a shape of cutting tool for indexable milling (BDMT11T308ER-JT). This was then subjected to debinding process, followed by sintering in vacuum of 0.01 Pa at 1450°C for one hour, thereby manufacturing cemented carbide. The surface of rake face of each sample was polished by blasting or brushing. The cemented carbide was further subjected to cutting edge treatment (honing) by brushing, so that the substrate was obtained.

A hard coating layer was formed on the substrate in various kinds of composition as shown in Table 3 by sputtering method. As for Sample No. II-7, a TiN layer having a thickness of 0.2 µm was formed on the surface of the first coating layer and the second coating layer shown in Table 3.

The surfaces of the hard coating layers of the samples thus obtained were observed with a scanning electronic microscope (SEM) or a transmission electron microscope (TEM), confirmed the presence of the first coating layer and the second coating layer, and measured the thickness, the crystal grain diameter of the granular crystal, and the mean crystal width of the columnar crystal in each coating layer. When a scanning electronic microscope (SEM) or a transmission electron microscope (TEM) was used for observation, the composition at any three points in each coating layer was measured with energy dispersive spectroscopy (EDS). Then, a mean value of the measured values was calculated as composition in each coating layer.

### Cutting Test

Next, under the following conditions, the cutting test of the obtained insert (cutting tool) having a shape of the cutting tool for indexable milling was conducted. The results are presented in Table 4.
Cutting method: Shoulder cutting (Milling process)
Work material: SKD11
Cutting speed: 150 m/min
Feed rate: 0.12 mm/tooth
Cutting depth: 10 mm in width of slot, 3 mm in depth of slot
Cutting condition: Dry cutting
Evaluation method: At the time that cutting was performed for 10 minutes, the presence of chipping was observed with a microscope, the height of flash that occurred in processed a work material was measured, and appearance of the cutting surface (namely, luster of appearance of the cutting surface) was qualitatively checked. As for height of flash, the values that obtained by measuring at five points were used to express the mean value, and the results are presented as the mean height of flash in Table 4.

**[Table 3]**

| Sample No. ¹⁾ | Bias voltage (V) | | Structure of hard coating layer | | | | | | | | |
|---|---|---|---|---|---|---|---|---|---|---|---|
| | | | First coating layer | | | | Second coating layer | | | | Whole thickness (µm) |
| | First coating layer | Second coating layer | Form of crystal | Mean crystal diameter (µm) | Composition | Thickness (µm) | Form of crystal | Mean crystal width (µm) | Composition | Thickness (µm) | |
| II-1 | 120 | 100 | Granular form | 0.06 | (Ti_{0.4}Al_{0.6})N | 0.5 | Columnar form | 0.18 | (Ti_{0.5}Al_{0.5})N | 2 | 2.5 |
| II-2 | 120 | 100 | Granular form | 0.07 | (Ti_{0.4}Al_{0.58}Y_{0.02})N | 0.2 | Columnar form | 0.15 | (Ti_{0.5}Al_{0.5})N | 2.3 | 2.5 |
| II-3 | 150 | 120 | Granular form | 0.06 | (Ti_{0.35}Al_{0.63}Ce_{0.02})(C_{0.5}N_{0.5}) | 0.5 | Columnar form | 0.15 | (Ti_{0.55}Al_{0.45})(C_{0.5}N_{0.5}) | 5.5 | 6 |
| II-4 | 120 | 90 | Granular form | 0.05 | (Ti_{0.1}Al_{0.7}Cr_{0.2}C_{0.5}N_{0.5}) | 0.3 | Columnar form | 0.2 | (Ti_{0.4}Al_{0.50}Cr_{0.2})(C_{0.5}N_{0.5}) | 4.2 | 4.5 |
| II-5 | 150 | 130 | Granular form | 0.04 | (Ti_{0.15}Al_{0.6}Cr_{0.2}Si_{0.05})N | 1.0 | Columnar form | 0.25 | (Ti_{0.5}Al_{0.5})N | 2 | 3 |
| II-6 | 150 | 100 | Granular form | 0.06 | (Ti₀₂₅Al_{0.6}Nb_{0.1}Si_{0.05})N | 0.8 | Columnar form | 0.23 | (Ti_{0.5}Al_{0.5})N | 2.2 | 3 |
| II-7 | 150 | 80 | Granular form | 0.07 | (Ti_{0.4}Al_{0.6})(C_{0.5}N_{0.5}) | 0.3 | Columnar form | 0.26 | (Ti_{0.5}Al_{0.5})(C_{0.5}N_{0.5}) | 2.5 | 3(2.8) |
| II-8 | 200 | 80 | Granular form | 0.08 | (Ti_{0.35}Al_{0.65})(C_{0.5}N_{0.5}) | 0.2 | Columnar form | 0.15 | (Ti_{0.55}Al_{0.45})N_{1.0} | 7 | 7.2 |
| II-9 | 250 | 150 | Granular form | 0.05 | (Ti_{0.35}Al_{0.55}Si_{0.1})N | 0.5 | Columnar form | 0.12 | (Ti_{0.5}Al_{0.5})N | 2.5 | 3 |
| II-10 | 150 | 80 | Granular form | 0.05 | (Ti_{0.1}Al_{0.56}Cr_{0.2}Si_{0.04})N | 0.5 | Columnar form | 0.16 | (Ti_{0.5}Al_{0.5})N | 4.5 | 5 |
| * II-11 | 80 | - | Granular form | 0.2 | (Ti_{0.5}Al_{0.5})N | 3 | - | | | | 3 |
| * II-12 | 50 | 300 | Columnar form | 0.12 | (Ti_{0.48}Al_{0.52})(C_{0.5}N_{0.5}) | 0.5 | Granular form | 0.08 | (Ti_{0.4}5Al_{0.35})(C_{0.5}N_{0.5}) | 2 | 2.5 |
| * II-13 | 100 | 100 | Granular form | 0.2 | (Ti_{0.4}Al_{0.5}Cr_{0.1})(C_{0.5}N_{0.5}) | 0.5 | Columnar form | 0.4 | (Ti_{0.65}Al_{0.43})N | 2.5 | 3 |
| * II-14 | 300 | 100 | Granular form | 0.2 | (Ti_{0.5}Al_{0.5})(C_{0.5}N_{0.5}) | 0.5 | Granular form | 0.2 | (Ti_{0.5}Al_{0.5})(C_{0.5}N_{0.5}) | 2.5 | 3 |
| * II-15 | 200 | 100 | Granular form | 0.05 | (Ti_{0.35}Al_{0.65})N | 2 | Columnar form | 0.2 | (Ti_{0.5}Al_{0.5})N | 2 | 4 |

| | | | | | | | | | | | |
|---|---|---|---|---|---|---|---|---|---|---|---|
| 1) The samples marked "*" are out of the scope of the present invention. | | | | | | | | | | | |

**[Table 4]**

| Sample No.¹⁾ | Quality of cutting surface | | |
|---|---|---|---|
| | Presence of chipping | Mean height of flash (mm) | Luster of appearance of cutting surface |
| II - 1 | None | 0.12 | ○ |
| II - 2 | None | 0.42 | ○ |
| II - 3 | None | 0.33 | ○ |
| II - 4 | None | 0.43 | ○ |
| II - 5 | None | 0.14 | ⊚ |
| II - 6 | None | 0.14 | ⊚ |
| II - 7 | None | 0.31 | ○ |
| II - 8 | None | 0.22 | ⊚ |
| II - 9 | None | 0.30 | ○ |
| II - 10 | None | 0.23 | ⊚ |
| * II - 11 | Presence | 1.12 | × |
| * II - 12 | Presence | 1.20 | × |
| * II - 13 | Initial fracture | 2.32 | - |
| * II - 14 | Presence | 1.50 | × |
| * II - 15 | Presence | 1.35 | × |

| | | | |
|---|---|---|---|
| 1) The samples marked "*" are out of the scope of the present invention. | | | |

According to the result shown in Tables 3 and 4, in Sample No. II-11 that was coated by only the first coating layer composed of the granular crystal, the finished surface was lusterless and height of flash was extremely high. It is presumed that the results were caused by occurrence of coating layer peeling quickly. In Sample No. II-12, in which the mean crystal diameter of the first coating layer was more then 0.1 µm, quality of the finished surface was poor because of the same reason. In Sample No. II-13, in which the mean crystal width of the second coating layer was more than 0.3 µm, hardness and wear resistance of the second coating layer decreased, and attrition was quickly caused, thereby fracture was caused. In the sample No. II-14, in which the mean crystal diameter of the first coating layer was more than 0.1 µm and the mean crystal diameter of the first coating layer was same as the mean crystal width of the second coating layer, inner stress of the hard coating layer increased, and toughness of the second coating layer decreased, so that fracture resistance thereby decreased. In Sample No. II-15, in which the thickness of the first coating layer was more than 1µm, there was no effect that the stress was relaxed by the coating layer having high fracture resistance like the second coating layer, so that fracture resistance of whole hard coating layer deteriorated.

On the other hand, in Sample Nos. II-1 to II-10 that were within the scope of the present invention, had a smooth and homogeneous hard coating layer with a high fracture resistance, and demonstrated an excellent finished surface roughness.

### Example III

### Manufacturing of Cutting Tools

A mixture was obtained by preparing cBN raw material powder having a mean grain diameter of 2.5 µm, TiC raw material powder having a mean grain diameter of 1.5 µm, TiN raw material powder having a mean grain diameter of 1.2 µm, TiCN raw material powder having a mean grain diameter of 1 µm, NbC raw material powder having a mean grain diameter of 1 µm, TaC raw material powder having a mean grain diameter of 1.1 µm, Ni raw material powder having a mean grain diameter of 0.9 µm, metal Al raw material powder having a mean grain diameter of 1.2 µm, and metal Co raw material powder having a mean grain diameter of 0.8 µm in order to be the composition shown in Table 5, and mixing for 16 hours in a ball mill using the ball made from alumina. Above mixture was then subjected to pressing under the pressure of 98 MPa. The green body thus obtained was subjected to heating at a pace shown in Table 5, with ultra-high pressure and temperature apparatus, followed by sintering under the pressure of 5.0 GPa at a temperature shown in Table 5 for a time shown in Table 5, and subjected to cooling at a pace shown in Table 5, thereby manufacturing cBN sintered body.

The base material having a shape of grooving chip, GBA43R300, manufactured by KYOCERA Corporation, was obtained by brazing the obtained cBN sintered body to the cemented carbide base that was separately prepared. The base material was subjected to cutting edge treatment (chamfer honing) by diamond wheel.

A coating layer was formed on the base material thus obtained in various kinds of composition as shown in Table 6 by sputtering method. The surfaces of the coating layers of the obtained samples were observed with a scanning electronic microscope (SEM) or a transmission electron microscope (TEM), confirmed the presence of the first coating layer and the second coating layer, and measured the thickness, the crystal grain diameter of the granular grain, and the mean grain width of the columnar grain in each coating layer. When a scanning electronic microscope (SEM) or a transmission electron microscope (TEM) was used for observation, the composition at any three points in each coating layer was measured with energy dispersive spectroscopy (EDS). Then, a mean value of the measured values was calculated as composition in each coating layer.

The maximum height Rz in the surface of the coating layer (the surface of the second coating layer) was measured at any three points with a probe type surface roughness meter, and a mean value of the measured values was calculated. The interface between the substrate and the first coating layer was traced with use of the photograph that was taken by the microscope for observation, and the obtained shape was used for measuring the maximum height Rz in the interface.

### Cutting Test

Next, under the following conditions, the cutting test of the obtained throwaway chip (cutting tool) having a shape of the cutting tool for grooving was conducted. The results are presented in Table 7.
Cutting method: Continuous turning end surface process
Work material: SCM435, HRC58 to 60, 30 mm of diameter
Cutting speed: 150 m/min (Max: 5000 rpm)
Feed rate: 0.05 mm/rev
Cutting depth: 0.1 mm in shoulder of slot, 0.2 mm in depth of slot
Cutting condition: Wet cutting
Evaluation method: The finished surface roughness (cutting surface roughness Ra) of the processed a work material was measured after 10 minutes cutting. Further, flank wear amount, tip wear amount and the presence of chipping were measured with a microscope after 20 minutes cutting.

**[Table 5]**

| Sample No.¹⁾ | Composition of mixture (% by volume) | | | | | Sintering condition | | | |
|---|---|---|---|---|---|---|---|---|---|
| | cBN | Component of binding phase | | | | Rate of temperature increase (°C/min) | Sintering temperature (°C) | Sintering time (min) | Rate of temperature decrease (°C/min) |
| III - 1 | The rest | TiC:25 | TiN:25 | Al:12 | - | 50 | 1400 | 15 | 50 |
| III - 2 | The rest | TiC:12 | TiN:15 | Al:6 | Co:4 | 30 | 1300 | 30 | 45 |
| III - 3 | The rest | NbC:15 | NbN:20 | Al:10 | - | 40 | 1400 | 20 | 30 |
| III - 4 | The rest | TaC:10 | TiN:12 | Al:15 | Ni:3 | 50 | 1250 | 25 | 50 |
| III - 5 | The rest | TiN:20 | Al:10 | Co:5 | - | 50 | 1400 | 15 | 50 |
| III - 6 | The rest | TiN:15 | Al:5 | Co:5 | - | 30 | 1300 | 30 | 45 |
| III - 7 | The rest | TiC:20 | Co:10 | - | - | 40 | 1400 | 20 | 30 |
| III - 8 | The rest | TiCN:25 | Al:10 | - | - | 50 | 1250 | 25 | 50 |
| III - 9 | The rest | TiCN:15 | TiN:10 | TiC:10 | Al:10 | 30 | 1350 | 30 | 40 |
| III - 10 | The rest | TiC:36 | Al:13 | - | - | 50 | 1400 | 10 | 100 |
| * III - 11 | The rest | TiN:39 | Al:9 | - | - | 50 | 1400 | 10 | 100 |
| * III - 12 | The rest | Al:6 | TiCN:27 | - | - | 50 | 1400 | 10 | 100 |
| * III - 13 | The rest | TiC:15 | TiN:15 | Al:10 | - | 50 | 1500 | 15 | 50 |
| * III - 14 | The rest | TiC:20 | TiN:10 | Al:15 | - | 50 | 1400 | 30 | 20 |
| * III - 15 | The rest | TiC:10 | TiN:20 | Al:8 | - | 100 | 1600 | 10 | 100 |

| | | | | | | | | | |
|---|---|---|---|---|---|---|---|---|---|
| 1) The samples marked "*" are out of the scope of the present invention. | | | | | | | | | |

**[Table 6]**

| Sample No.¹⁾ | Bias voltage (V) | | Structure of coating layer | | | | | | | | |
|---|---|---|---|---|---|---|---|---|---|---|---|
| | | | First coating layer | | | | Second coating layer | | | | Whole thickness (µm) |
| | First coating layer | Second coating layer | Form of grain | Mean grain diameter (µm) | Composition | Thickness (µm) | Form of grain | Mean grain width (µm) | Composition | Thickness (µm) | |
| III - 1 | 120 | 100 | Granular form | 0.09 | (Ti_{0.5}Al_{0.5})N | 0.5 | Columnar form | 0.18 | (Ti_{0.4}Al_{0.6})N | 1.5 | 2 |
| III-2 | 150 | 120 | Granular form | 0.08 | (Ti_{0.6}Al_{0.4})N | 0.2 | Columnar form | 0.15 | (Ti_{0.45}Al_{0.55})N | 1.5 | 1.7 |
| III - 3 | 200 | 90 | Granular form | 0.04 | (Ti_{0.5}Al_{0.5})N | 0.5 | Columnar form | 0.25 | (Ti_{0.5}Al_{0.5})N | 2 | 2.5 |
| III - 4 | 125 | 80 | Granular form | 0.07 | (Ti_{0.4}Al_{0.50}Cr_{0.1})(C_{0.5}N_{0.5}) | 0.3 | Columnar form | 0.27 | (Tl_{0.1}Al_{0.75}Cr_{0.15})(C_{0.5}N_{0.5}) | 1.7 | 2 |
| III- 5 | 145 | 100 | Granular form | 0.06 | (Ti_{0.5}Al_{0.5})N | 1.0 | Columnar form | 0.17 | (Ti_{0.05}Al_{0.7}Cr_{0.1}Si_{0.05})N | 2.8 | 3.8 |
| III - 6 | 150 | 125 | Granular form | 0.06 | (Ti_{0.5}Al_{0.5})N | 0.8 | Columnar form | 0.14 | (Ti_{0.25}Al_{0.6}Nb_{0.1}Si_{0.05})N | 2.5 | 3.3 |
| III - 7 | 140 | 80 | Granular form | 0.07 | (Ti_{0.5}Al_{0.5})(C_{0.5}N_{0.5}) | 0.3 | Columnar form | 0.26 | (Ti_{0.4}Al_{0.6})(C_{0.5}N_{0.5}) | 2 | 2.3 |
| III-8 | 210 | 90 | Granular form | 0.04 | (Ti_{0.55}Al_{0.45})N 1.0 | 0.2 | Columnar form | 0.25 | (Ti_{0.35}Al_{0.65})(C_{0.5}N_{0.5}) | 3 | 3.2 |
| III-9 | 250 | 150 | Granular form | 0.03 | (Ti_{0.5}Al_{0.5})N | 0.5 | Columnar form | 0.12 | (Ti_{0.35}Al_{0.55}Si_{0.1})N | 2.5 | 3 |
| III - 10 | 170 | 100 | Granular form | 0.05 | (Ti_{0.52}Al_{0.43}W_{0.02}Nb_{0.02}Si_{0.01})N | 0.5 | Columnar form | 0.16 | (Ti_{0.46}Al_{0.49}W_{0.02}Nb_{0.02}Si_{0.01})N | 2.5 | 3 |
| * III - 11 | 80 | - | Granular form | 0.2 | (Ti_{0.5}Al_{0.5})N | 3 | - | | | | 3 |
| * III - 12 | 50 | 300 | Columnar form | 0.12 | (Tl_{0.48}Al_{0.52})(C_{0.5}N_{0.5}) | 0.5 | Granular form | 0.08 | (Ti_{0.45}Al_{0.55})(C_{0.5}N_{0.5}) | 2 | 2.5 |
| * III - 13 | 100 | 100 | form | 0.2 | (Tl_{0.4}Al_{0.5}Cr_{0.1})(C_{0.5}N_{0.5}) | 0.5 | Columnar form | 0.4 | (Ti_{0.65}Al_{0.45})N | 2.5 | 3 |
| * III - 14 | 300 | 100 | Granular form | 0.2 | (Ti_{0.5}Al_{0.5})(C_{0.5}N_{0.5}) | 0.5 | Granular form | 0.2 | (Ti_{0.5}Al_{0.5})(C_{0.5}N_{0.5}) | 2.5 | 3 |
| * III - 15 | 200 | 100 | Granular form | 0.01 | (Ti_{0.35}Al_{0.65})N | 2 | Columnar form | 0.6 | (Ti_{0.5}Al_{0.5})N | 2 | 4 |

| | | | | | | | | | | | |
|---|---|---|---|---|---|---|---|---|---|---|---|
| 1) The samples marked "*" are out of the scope of the present invention. | | | | | | | | | | | |

**[Table 7]**

| Sample No.¹⁾ | Surface roughness Rz (µm) | | Cutting performance | | | | |
|---|---|---|---|---|---|---|---|
| | Interface | Surface of coating layer | Presence of chipping | Flank wear (mm) | Tip wear (mm) | roughness Ra (µm) | State of cutting edge |
| III - 1 | 0.17 | 0.26 | None | 0.13 | 0.11 | 0.15 | Normal |
| III - 2 | 0.05 | 0.12 | None | 0.17 | 0.17 | 0.07 | Normal |
| III - 3 | 0.27 | 0.42 | None | 0.2 | 0.16 | 0.22 | Normal |
| III - 4 | 0.28 | 0.49 | None | 0.20 | 0.19 | 0.24 | Normal |
| III - 5 | 0.11 | 0.21 | None | 0.14 | 0.08 | 0.17 | Normal |
| III - 6 | 0.03 | 0.09 | None | 0.12 | 0.14 | 0.17 | Minute welding |
| III - 7 | 0.05 | 0.13 | None | 0.14 | 0.14 | 0.10 | Normal |
| III - 8 | 0.03 | 0.08 | None | 0.11 | 0.1 | 0.18 | Minute welding |
| III - 9 | 0.01 | 0.05 | None | 0.18 | 0.16 | 0.05 | Normal |
| III - 10 | 0.14 | 0.22 | None | 0.14 | 0.12 | 0.14 | Normal |
| * III - 11 | 0.40 | 0.44 | Presence | 0.35 | 0.31 | 0.33 | Large welding |
| * III - 12 | 0.30 | 0.50 | Presence | 0.32 | 0.35 | 0.50 | Layer peeling |
| * III - 13 | 0.20 | 0.15 | Presence | 0.30 | 0.33 | 0.42 | Layer peeling |
| * III - 14 | 0.01 | 0.01 | Presence | 0.40 | 0.45 | 0.21 | Large welding |
| * III - 15 | 0.03 | 0.02 | Presence | 0.38 | 0.35 | 0.27 | Large welding |

| | | | | | | | |
|---|---|---|---|---|---|---|---|
| 1) The samples marked "*" are out of the scope of the present invention. | | | | | | | |

According to the result shown in Tables 5 to 7, in Sample No. III-11 that was coated by only the first coating layer composed of granular grain, welding occurred on the cutting edge, chipping occurred quickly, the tool life was short, and cutting surface roughness of a work material was coarse. In Sample No. III-12, in which the mean grain diameter of the first coating layer was more than 0.1 µm, the tool life was also short due to occurrence of chipping quickly. In Sample No. III-13, in which the mean grain width of the second coating layer was more than 0.3 µm, hardness and wear resistance of the second coating layer deteriorated. In Sample No. III-14, in which the mean grain diameter of the first coating layer was more than 0.1 µm and the mean grain diameter of the first coating layer was same as the mean grain width of the second coating layer, inner stress of the coating layer increased, and toughness of the second coating layer decreased, so that fracture resistance decreased. In the Sample No. III-15, in which the thickness of the first coating layer was more than 1 µm, there was no effect that was relaxing stress by the coating layer having high fracture resistance like the second coating layer, so that fracture resistance of whole hard coating layer deteriorated.

On the other hand, in Sample Nos. III-1 to I-10, the cutting performances, which were the homogeneous hard coating layer, small surface roughness, excellent fracture resistance, and successful quality of the finished surface, were respectively exerted. In Sample Nos. III-1 and III-2, in which both TiN and TiC were contained in component of the binding phase of the substrate, adhesiveness was excellent in spite of the thin coating layer having a whole thickness of less than 2 µm, and both fracture resistance and wear resistance were excellent, so that successful cutting performance exerted.

### Example IV

### Manufacturing of Cutting Tools

A cBN sintered body having the same composition of Sample No. III-1 that was prepared in the Example III were prepared, which was brazed to the cemented carbide base having a shape of TNGA 160408 that was prepared separately, thereby a base material was obtained. The base material was subjected to cutting edge treatment (chamfer honing) by diamond wheel.

The hard coating layer which was same as Sample No. III-1 in Table 6 was formed on the base material thus obtained by sputtering method.

### Cutting Test

Next, under the following conditions, the cutting test of the obtained throwaway chip (cutting tool) was conducted.
Cutting method: Continuous turning end surface process
Work material: SCM435, HRC58 to 60, 30 mm of diameter
Cutting speed: 150 m/min
Feed rate: 0.05 mm/rev
Cutting depth: 0.1 mm
Cutting condition: Wet cutting

According to the results of the cutting test, the finished surface roughness (cutting surface roughness Ra) of the processed a work material after 10 minutes cutting was as smooth as 0.12 µm. Further, wear resistance after 20 minutes cutting was extremely excellent such as 0.13 mm of frank wear and 0.10 mm of tip wear, and fracture such as chipping was not observed on the cutting edge.

While the preferred embodiments of the present invention have been described and illustrated above, it is to be understood that the invention is not limited to the above embodiments and applicable to those in which modification and improvements are made thereto without departing from the gist of the invention. For example, although the foregoing embodiments are directed to the cases where the surface coated tool is applied to cutting tools, the use of the surface coated tool of the invention is not limited thereto. The surface coated tool is preferably applied to milling cutting tools, rotating tools such as drills and end mills, as well as wear resistance tools having purposes other than cutting, such as punches, dies and slitters.

The invention is not limited to the surface coated tools according to the tool 1 and the tool 21, respectively. Alternatively, the invention may be applied to a surface coated tool according to an embodiment as a combination of the tool 1 and the tool 21.

## Claims

1. A surface coated tool comprising a substrate, and a hard coating layer comprising two coating layers stacked on the substrate and represented by the following general formula (1),
wherein, a first coating layer to be coated on the surface of the substrate, which has a thickness of 0.1 to 1 µm, is composed of a granular crystal having a mean crystal diameter of 0.01 to 0.1µm; and
a second coating layer to be coated on the surface of the first coating layer, which has a thickness of 0.5 to 10 µm, is composed of columnar crystal grown in a direction perpendicular to the substrate, and the columnar crystal has a mean crystal width of 0.05 to 0.3µm in a direction parallel to the substrate, and a mean crystal width thereof is larger than the mean crystal diameter of the first coating layer.
[Formula 2] M₁-ₐAlₐ(C_{b}N_{1-b}) (1)
wherein, M represents at least one metal element selected from the group consisting of the elements of Groups 4, 5 and 6 of the periodic table, Si and rare earth elements, "a" satisfies the relation of 0.25 ≤ a ≤ 0.75, and "b" satisfies the relation of 0 ≤ b ≤ 1.

2. The surface coated tool according to claim 1, wherein "a" in the general formula (1) satisfies the relation of 0.55 ≤ a ≤ 0.75 in the first coating layer.

3. The surface coated tool according to claim 1, wherein "a" in the general formula (1) satisfies the relation of 0.4 ≤ a ≤ 0.55 in the second coating layer.

4. The surface coated tool according to any one of claims 1 to 3, wherein a TiN layer having a thickness of 0.05 to 1µm is on the surface of the second coating layer.

5. The surface coated tool according to any one of claims 1 to 4, wherein the coating layer is a sputtering film.

6. The surface coated tool according to any one of claims 1 to 5, wherein the substrate comprises a cubic boronitride sintered body formed by bonding a hard phase composed mainly of cubic boronitride with a binding phase.

7. The surface coated tool according to claim 6, wherein the binding phase contains titanium nitride and titanium carbide.

8. The surface coated tool according to claim 6 or 7, wherein the coating layer has an unpolished surface and the maximum height Rz thereof is in the range of 0.05 to 0.5µm.

9. A method of manufacturing a work piece, comprising the steps of:
preparing a cutting tool comprising a surface coated tool according to any one of claims 1 to 8, having a cutting edge formed at a crossed ridge portion between a rake face and a flank face;
bringing the cutting edge into contact with a surface of a work material;
cutting the work material by rotating the cutting edge; and
taking the cutting edge away from the surface of the work material.

10. The method of manufacturing the work piece according to claim 9, wherein the substrate of the surface coated tool comprises the cubic boronitride sintered body according to any one of claims 6 to 8, and the work material comprises hardened steel having the diameter of 30 mm and below.
